# EUROPEAN PATENT APPLICATION

(11) **EP 2 194 166 A1**
(43) Date of publication of application: **09.06.2010**
(21) Application number: 08825826.4
(22) Date of filing: 29.09.2008
(51) Int. Cl.: C30B 15/10, C03B 20/00

(54) **SILICA GLASS CRUCIBLE, PROCESS FOR PRODUCTION OF THE SAME, AND PULLING METHOD**

(30) Priority: 28.09.2007 JP 2007256155
(71) Applicant: Japan Super Quartz Corporation, Akita City Akita 010-0065 (JP)
(72) Inventor: KANDA, Minoru, Akita-shi Akita 010-0065 (JP)
(74) Representative: Albrecht, Thomas
(86) International application number: PCT/JP2008/067651
(87) International publication number: WO 2009/041684

(57) **Abstract**

A silica glass crucible including an outer surface layer formed of a bubble-containing silica glass layer and an inner surface layer formed of a silica glass layer whose bubbles are invisible to the naked eye, so as to sufficiently disperse heat from the external radiation thereby preventing temperature irregularity in the silicon melt, and at the same time, exhibit excellent heat conductivity thereby giving a uniformly heated state over a wide range in the entire crucible without taking a long time for increasing the temperature to form a silicon melt, wherein an intermediate layer is interposed between the outer surface layer and the inner surface layer while in the intermediate layer, a bubble-containing silica glass layer (bubble-containing layer) including bubbles with a diameter of 100 µm or smaller by 0.1 % or more in the volumetric bubble content and a silica glass layer (transparent glass layer) including the bubbles by 0.05% or less in the volumetric bubble content are laminated.

## Description

### Technical Field

The present invention relates to a silica glass crucible having an excellent heat conducting effect and uniform heat conductivity, and a method of manufacturing the same, as well as an application thereof.
Priority is claimed on Japanese Patent Application No. 2007-256155, filed September 28, 2007, the content of which is incorporated herein by reference.

### Background Art

A silica glass crucible to be filled with a silicon melt is used for pulling single-crystal silicon. The inner surface of this silica glass crucible is formed of a transparent glass layer including substantially no bubbles because it has to be in contact with a silicon melt, and the outer surface thereof is formed of a bubble-containing layer including a number of bubbles so as to uniformly transfer heat from the outer part to the inside of a mold.

A rotary mold method is conventionally known as a method of manufacturing the above-mentioned silica glass crucible. This is a method of manufacturing a crucible by heating a quartz powder accumulated on the inner surface of a rotary mold from a space side of the mold for vitrification, wherein during this heating and melting, evacuation is performed to remove bubbles in a glass layer by sucking air in the quartz powder-deposited layer from the mold side to reduce the pressure thereby forming on the inner surface of the crucible a transparent glass layer containing substantially no bubbles (JP-ANo. H02-055285 and JP-A No. H10-017391). In addition, a spraying method is known as a method of manufacturing the silica glass crucible. This is a method of manufacturing a silica glass crucible by spraying molten quartz onto an inner surface of the mold (JP-A No. H01-148718 and JP-A No. H01-148782).

The existing silica glass crucible manufactured by any of a rotary mold method and a spraying method, which is used for pulling single-crystal silicon, has a two-layer constitution including a transparent glass layer in the inner side and a bubble-containing layer in the outer side. In a crucible having such a constitution, heat from the heated outer part is dispersed by the bubble-containing layer of the outer surface, and thus a silicon melt can be prevented from being locally heated, thereby hardly causing temperature irregularity in the silicon melt. In addition, since the transparent glass layer of the inner surface contains substantially no bubbles, a separation bubble does not occur and thus there is an advantage of reducing the dislocation content upon pulling single-crystal silicon.

### Disclosure of the Invention

### Problems to be Solved by the Invention

However, in the case of a constitution including only one layer of a bubble-containing layer for the outer surface, even though it does not give a temperature irregularity in the silicon melt, a longer time for increasing the temperature to heat and melt a silicon material charged in the crucible is required because the heat conduction is disrupted by the bubble-containing layer. Moreover, a temperature difference in areas over the whole crucible, for example, between the upper part and the bottom part of the crucible, tends to occur due to the low heat conduction, and consequently, a temperature irregularity (difference) tends to become significant in the entire crucible interface and silicon melt.

When, for example, a hot area is formed on a part of the silica glass interface due to such a temperature irregularity (difference), a SiO gas is likely to be produced from the area. According to the increase of SiO gas and burst on the gas-liquid interface, vibration of the melt surface of a silicon melt is generated upon pulling and this vibration of the melt surface becomes significant, thereby becoming the cause of dislocation of the pulled single-crystal silicon.

The present invention has solved the problems in a known silica glass crucible, which provides a silica glass crucible capable of sufficiently dispersing heat from the external radiation thereby preventing temperature irregularity in the silicon melt, and at the same time, exhibiting excellent heat conductivity thereby giving a uniformly heated state over a wide range in the entire crucible without taking a long time for increasing the temperature to form a silicon melt, which also provides a manufacturing method thereof.

### Means for Solving the Problems

The invention relates to a silicon glass crucible which has solved the above-mentioned problems by employing the following constitutions shown in [1] to [3].
[1] A silica glass crucible wherein an outer surface layer is formed of a bubble-containing silica glass layer and an inner surface layer is formed of a silica glass layer whose bubbles are invisible to the naked eye, the crucible being characterized by including an intermediate layer interposed between the outer surface layer and the inner surface layer, where in the intermediate layer, a bubble-containing silica glass layer (bubble-containing layer) including bubbles with a diameter of 100 µm or smaller by 0.1 % or more in the volumetric bubble content and a silica glass layer (transparent glass layer) including the bubbles by 0.05% or less in the volumetric bubble content are laminated.
[2] The silica glass crucible described in [1] above, wherein the layer thickness of both the bubble-containing layer and the transparent glass layer which constitute the intermediate layer is 0.5 mm or more.
[3] The silica glass crucible described in any [1] or [2] above, wherein an intermediate layer in which the plurality of bubble-containing layers and transparent glass layers are laminated in the alternate manner is interposed between the outer surface layer and the inner surface layer.

In addition, the invention relates to a method of manufacturing a silica glass crucible and a pulling method which have solved the above-mentioned problems by employing the following constitutions shown in [4] to [7].
[4] A method of manufacturing a silica glass crucible, including heating and melting a quartz powder accumulated on the inner surface of a rotary mold from a space side of the mold, where upon the heating and melting, evacuation is performed to remove bubbles by sucking air in the quartz powder-deposited layer from the mold side, the method being characterized by intermittently performing evacuation and leakage to form a laminated layer of bubble-containing layers and transparent glass layers between the outer surface layer and the inner surface layer.
[5] The manufacturing method described in [4] above, wherein an intermediate layer in which the plurality of bubble-containing layers and transparent glass layers are laminated in the alternate manner is formed between the outer surface layer and the inner surface layer by intermittently performing evacuation and leakage several times.
[6] The manufacturing method described in any [4] or [5] above, wherein, upon intermittently performing the evacuation and leakage, a mixed gas containing 50% or more of helium gas is introduced as the leak gas.
[7] A method of pulling single-crystal silicon with the use of the silica glass crucible described in any one of [1] to [6] above.

### Effects of the Invention

The silica glass crucible of the invention includes between the outer surface layer and the inner surface layer an intermediate layer in which bubble-containing layers and transparent glass layers are laminated, and thus heat from the external radiation is dispersed by the bubble-containing layers thereby conducting heat over a wide range. Consequently, the temperature distribution of a silica glass interface of the crucible which comes into contact with a silicon melt becomes uniform over a wide range and thus the silicon melt is uniformly heated. Therefore, temperature irregularity in the silicon melt does not occur. Moreover, since a transparent glass layer is constituted in addition to the bubble-containing layer, heat dispersed by the bubble-containing layers is efficiently transferred via the transparent glass layer, and thus the property of conducting heat from the high-temperature radiation is significantly improved.

Furthermore, the silica glass crucible of the invention is not provided with a locally hot area heated by external radiation, and furthermore, the invention provides temperature uniformity in the silica glass interface at low temperature as compared to the known two-layer structured silica glass crucible. Therefore, vibration of the melt surface caused by a SiO gas generation is not generated upon pulling single-crystal silicon.

The silica glass crucible of the invention can be manufactured by intermittently performing evacuation and leakage processes in the method of manufacturing a silica glass crucible according to a rotary mold method. Also, an intermediate layer in which the plurality of bubble-containing layers and transparent glass layers are laminated can be formed by intermittently performing evacuation and leakage.

The laminated structure of the bubble-containing layers and the transparent glass layers of the invention is formed by alternately performing an operation of keeping the area around a quartz powder of a molten part vacuous when the quartz powder is in a molten state, and an operation of leakage. That is, this structure cannot be formed by the known spraying method wherein evacuation and leakage are not performed.

In the manufacturing method of the invention, helium gas, which has high heat conductivity, is used as the leak gas upon repeatedly performing intermittent evacuation and leakage. Accordingly, the effect of increasing the temperature by external heating is improved significantly thereby promoting the uniform heating of a silica glass interface.

### Brief Description of the Drawings

FIG. 1 is a cross-sectional view illustrating a silica glass crucible related to the invention.
FIG. 2 is a cross-sectional view schematically showing a side-wall part of the silica glass crucible (intermediate layer of single constitution) related to the invention.
FIG. 3 is a cross-sectional view schematically showing a side-wall part of the silica glass crucible (intermediate layer of dual constitution) related to the invention.
FIG. 4 is a view schematically showing a manufacturing device for the silica glass crucible related to the invention.
FIG. 5 is a time chart showing a manufacturing method of the silica glass crucible (intermediate layer of single constitution) related to the invention.
FIG. 6 is a time chart showing a manufacturing method of the silica glass crucible (intermediate layer of dual constitution) related to the invention.
FIG. 7 is a cross-sectional view schematically showing pulling of single-crystal silicon with the silica glass crucible related to the invention.

### Reference Numerals

- C1:: outer surface layer (outer side bubble-containing layer)
- C2:: inner surface layer (bubble-free transparent glass layer)
- C3:: bubble-containing layer
- C4:: transparent glass layer
- C5:: intermediate layer

### Best Mode for Carrying Out the Invention

Hereinbelow, the invention will be described in detail with reference to exemplary embodiments.

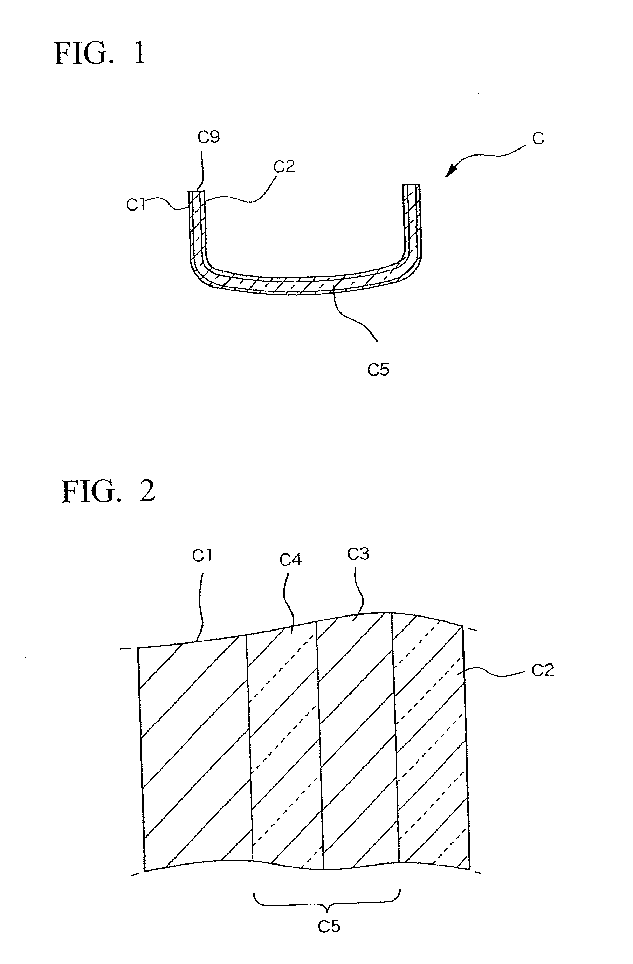

For a silica glass crucible of the invention, as shown in FIGS. 1 to 3, an outer surface layer C1 is formed of a bubble-containing silica glass layer and an inner surface layer C2 is formed of a silica glass layer whose bubbles are invisible to the naked eye. In the silica glass crucible C of the invention, an intermediate layer C5 in which a bubble-containing silica glass layer (bubble-containing layer) including bubbles with a diameter of 100 µm or smaller by 0.1% or more in the volumetric bubble content and a silica glass layer (transparent glass layer) including the bubbles by 0.05% or less in the volumetric bubble content are laminated, is interposed between the outer surface layer C1 and the inner surface layer C2.

For an exemplary structure for the silica glass crucible of the invention, a cross-sectional view of the side-wall part is schematically shown in FIG. 2. As shown in the figure, the silica glass crucible C of the invention includes the outer surface layer C1 (outer side bubble-containing layer) formed of a bubble-containing silica glass layer and the inner surface layer C2 (bubble-free transparent glass layer) formed of a silica glass layer whose bubbles are invisible to the naked eye, and the intermediate layer C5 is interposed between the outer surface layer C 1 and the inner surface layer C2. The intermediate layer C5 is formed of the bubble-containing layer C3 and the transparent glass layer C4.

The bubble quantity and the layer thickness for the bubble-containing silica glass layer of the outer surface layer C1 are not particularly limited and may be the same as those for the outer surface layer of the known silica glass crucible. The inner surface layer C2 is formed of a silica glass layer (bubble-free transparent glass layer) whose bubbles are invisible to the naked eye, and the layer thickness thereof is greater than the thickness that erodes by the silicon melt.

In the silica glass crucible C of the invention, the bubble-containing layer C3 constituting the intermediate layer C5 contains bubbles having a diameter of 100 µm or less by 0.1% or more in a volumetric bubble content, and it is a silica glass layer having a layer thickness of preferably 0.5 mm or more, more preferably 0.5 to 4 mm.

When the bubble content in the bubble-containing layer C3 is less than 0.1 %, heat from the radiation outside cannot be sufficiently dispersed, thus it is not preferable. When a diameter of the bubbles in the bubble-containing layer is larger than 100 µm, the bubble diameter becomes substantially large during the use under high temperature for pulling because of the bubble expansion, which then lowers the effect of uniform heat dispersion thereby causing irregularity in the inner surface temperature of the crucible, thus it is not preferable.

When the layer thickness of the bubble-containing layer C3 is less than 0.5 mm, heat radiation from outside cannot be sufficiently dispersed, thus it is not preferable. Meanwhile, when the layer thickness of the bubble-containing layer C3 is too great, the heat conducting effect is lowered and a longer time to increase the temperature when forming a silicon melt will be required, and also temperature irregularity after melting readily occurs due to the low heat transfer. Therefore, the layer thickness of the bubble-containing layer C3 is preferably from 0.5 to 4 mm.

In the silica glass crucible C of the invention, the transparent glass layer C4 constituting the intermediate layer C5 is a silica glass layer having a volumetric bubble content of 0.05% or less and layer thickness of preferably 0.5 to 4 mm.
When the bubble content of the transparent glass layer is larger than 0.05%, its transparency deteriorates and the effect of transferring the heat from the external radiation is lowered, thus it is not preferable. When the layer thickness of the transparent glass layer C4 is less than 0.5 mm, the effect of increasing the heat transfer by the transparent glass layer becomes insufficient. Meanwhile, when the layer thickness is greater than 4 mm, heat that escapes from the upper-edge rim of the crucible C becomes too significant thereby giving poor heat efficiency, thus it is not preferable.

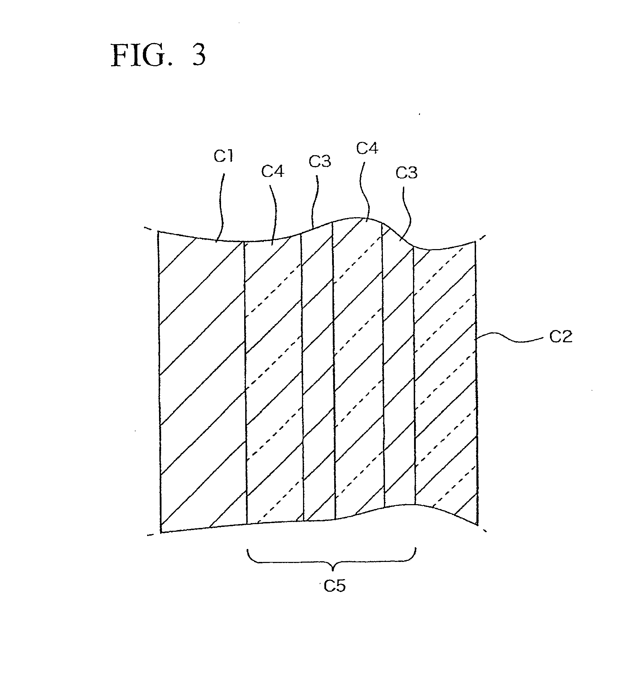

As shown in FIG. 3, the intermediate layer C5 interposed between the outer surface layer C1 and the inner surface layer C2 may be constituted by laminating the plurality of bubble-containing layers C3 and transparent glass layers C4 in an alternate manner. In an example shown in FIG. C2, the bubble-containing layer C3 and the transparent glass layer C4 are alternately laminated, and this combination of bubble-containing layer C3 and transparent glass layer C4 is formed twice thereby giving two laminations, but the number of laminations including a combination of the bubble-containing layer C3 and the transparent glass layer C4 is not limited. Also, in the example shown in the figure, the bubble-containing layer C3 is formed on the inner surface layer side and the transparent glass layer C4 is formed on the outer surface side, but the order of the lamination for the intermediate layer C5 is not limited thereto.

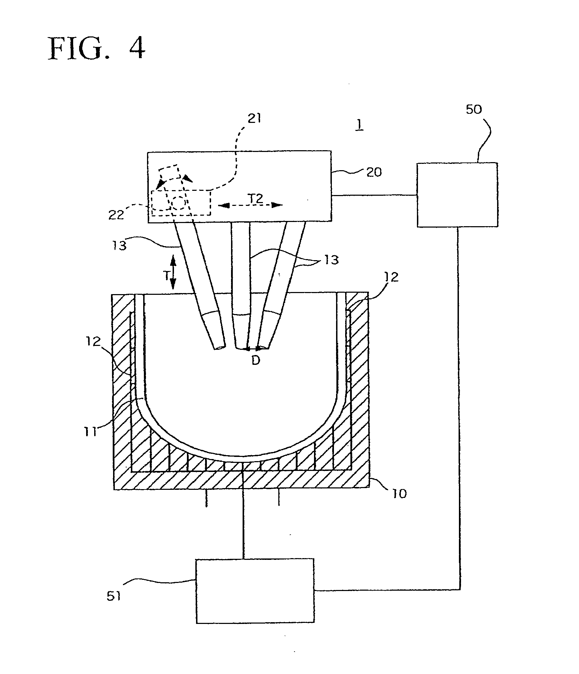

The silica glass crucible C of the invention can be manufactured by using a manufacturing device of a silica glass crucible shown in FIG. 4.
The silica glass crucible manufacturing device 1 is roughly constituted by, as shown in FIG. 4, a mold 10 which has a melting space in the inner part for melting a quartz powder and forming a quartz glass crucible, a driving mechanism not shown in the figure which rotates the mold 10 round the axis, and a plurality of carbon electrodes 13 which acts as an arc discharge means for heating the inner side of the mold 10.

The mold 10 is formed of, for example, carbon, and a number of pressure-reducing passages 12 which are open to the surface of inner part of the mold 10 are formed in the inside, as shown in FIG. 4. The pressure-reducing passage 12 is connected with a pressure-reducing mechanism 51 which thus allows a suction of air from the inner surface of the mold 10 via the pressure-reducing passage 12 at the time of rotating the mold 10.
The pressure-reducing mechanism 51 and the arc discharge means are connected with a control means 50, and they are controlled by this control means 50. In addition, the pressure-reducing means 51 is capable of switching over between an evacuation (reducing pressure) state and a leakage (introducing a leak gas to the mold side) state.

A plurality of electrodes 13 is provided as the arc discharge means at the upper side of the mold 10 in the silica glass crucible manufacturing device 1. In the example shown in the figure, the electrode 13 is formed in a combination of three electrodes. The electrodes 13 are each fixed to a support 22 at the upper part of a furnace, and the support 22 is provided with a means (omitted in the figure) to vertically move the electrode 21.

The support 22 is provided with a supporting part 21 that supports the carbon electrode 13 while allowing setting of the distance between the electrodes, a horizontally transferring means that allows the supporting part 21 to move in a horizontal direction, and a vertically transferring means that allows the plurality of supporting parts 21 and the respective horizontally transferring means to move integrally in a vertical direction. The supporting part 21 does the supporting by allowing the carbon electrode 13 to move round an angle setting axis 22, and is provided with a rotation means that controls the rotation angle of the angle setting axis 22. In order to adjust the distance D between the carbon electrodes 13, the angle of the carbon electrode 13 is controlled by the rotation means, as well as the horizontal position of the supporting part 21 being controlled by the horizontally transferring means and the height of the supporting part 21 is also controlled by the vertical transferring means.
The supporting part 21 and the like are shown in only the left end of the carbon electrode 13 in the figure, but other electrodes are also supported by the same constitution and the height of each carbon electrode 13 can be controlled individually.

As the method of manufacturing a silica glass crucible according to the invention, a rotary mold method with the use of the quartz glass crucible manufacturing device 1 is employed for the production, and a quartz-powder filling step, an arc melting step, a cooling step, a taking-out step, a honing processing step, a rim cutting step and a washing step are included for the production.
In the quartz-powder filling step, a quartz-powder layer 11 is formed by depositing a quartz raw powder on the inner surface of the mold 10. This quartz-powder layer 11 is held on the inner-wall surface by the centrifugal force from the rotation of the mold 10.
In the arc melting step, a position of the electrode 13 is arranged, and a pressure is reduced and a leak gas is introduced through the pressure-reducing passage 12 while heating the left quartz-powder layer 11 with the arc discharge means, thereby melting the quartz-powder layer 11 to form a quartz glass layer.

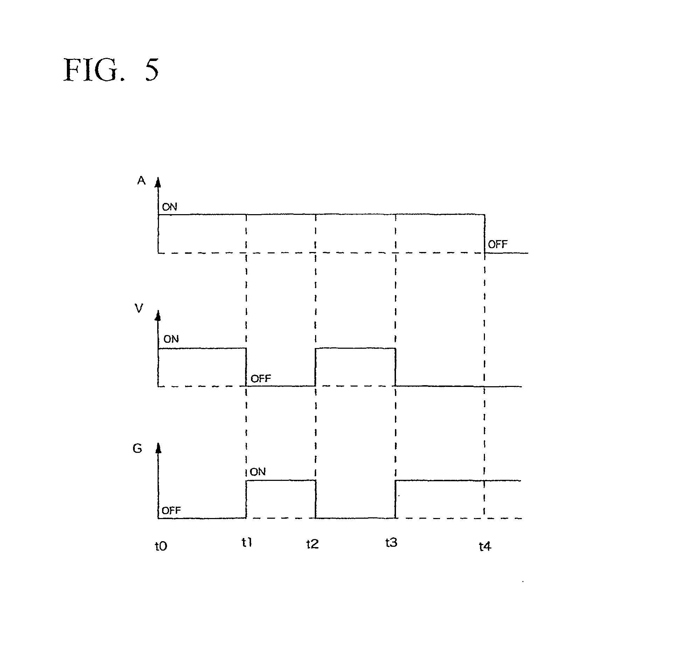

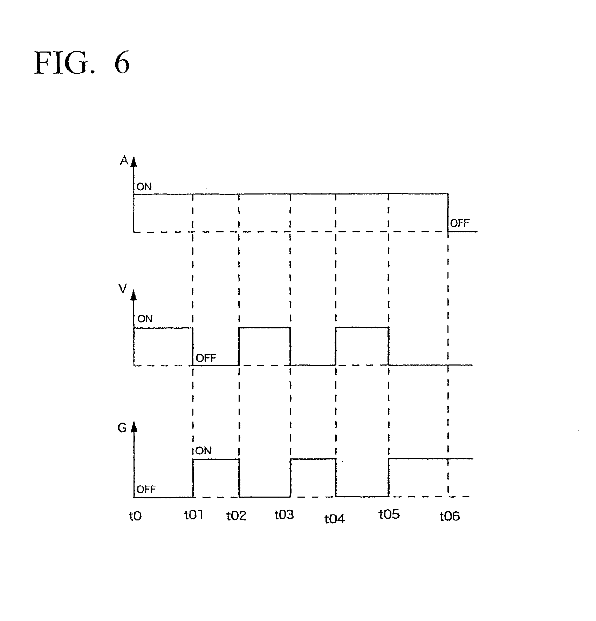

In the method of manufacturing a silica glass crucible according to the invention, a quartz powder accumulated on the inner surface of the rotary mold is heated from the mold space side so as to be melted, and when performing an evacuation to remove bubbles by sucking air in the quartz powder-deposited layer from the mold side during the heating and melting, evacuation and leakage are intermittently performed as shown in FIG. 5 and FIG. 6 for the production.

Specifically, by the control with the control means 50, when the arc melting which is shown as A in FIG. 5 is initiated at time t0, a suction mode given with the pressure-reducing means 51 which is shown as V in the figure is initiated at the same time of time t0. These are indicated as 'ON' in the figure. In this manner, the quartz-powder laminate 11 starts to melt from the surface at a space side (electrode 13 side) of the mold 10. This melting of the quartz-powder laminate 11 starts from the area corresponding to the outer side surface of the inner surface layer (bubble-free transparent glass layer) C2 and proceeds towards the inner side. The introduction of a leak gas by the pressure-reducing means 51 which is shown as G in the figure is not performed. This is indicated as 'OFF' in the figure.

Next, at time t1 shown in FIG. 5, when a molten state of the quartz-powder laminate 11 reaches a position corresponding to the outer side surface of the inner surface layer (bubble-free transparent glass layer) C2, that is, a thickness position corresponding to the inner side surface of the bubble-containing layer 3, a suction mode given with the pressure-reducing means 51 which is shown as V in the figure is stopped and at the same time, introduction of a leak gas with the pressure-reducing means 51 which is shown as G in the figure is initiated, by the control with the control means 50. For the leak gas, air or gases such as helium which will be described later can be selected.

Next, at time t2 shown in FIG. 5, when a molten state of the quartz-powder laminate 11 reaches a position corresponding to the outer side surface of the bubble-containing layer 3, that is, a thickness position corresponding to the inner side surface of the transparent glass layer 4, a suction mode given with the pressure-reducing means 51 which is shown as V in the figure is initiated and at the same time, introduction of a leak gas with the pressure-reducing means 51 which is shown as G in the figure is stopped, by the control with the control means 50.

At time t3 shown in FIG. 5, when a molten state of the quartz-powder laminate 11 reaches a position corresponding to the outer side surface of the transparent glass layer 4, that is, a thickness position corresponding to the inner side surface of the outer surface layer 1, a suction mode given with the pressure-reducing means 51 which is shown as V in the figure is stopped and at the same time, introduction of a leak gas with the pressure-reducing means 51 which is shown as G in the figure is initiated, by the control with the control means 50.

At time t4 shown in FIG. 5, when a molten state of the quartz-powder laminate 11 reaches a thickness position corresponding to the outer side surface of the outer surface layer 1, the arc melting shown as A in the figure is stopped by the control with the control means 50, and a cooling process is initiated.

In the arc melting step, at the time between t0 and t1, removal of bubbles from the corresponding area (inner surface layer C2) of a silica glass crucible is carried out, at the time between t1 and t2, introduction of bubbles to the corresponding area (bubble-containing layer 3) of a silica glass crucible is carried out, at the time between t2 and t3, removal of bubbles from the corresponding area (transparent glass layer 4) of a silica glass crucible is carried out, and at the time between t3 and t4, introduction of bubbles to the corresponding area (outer surface layer 1) of a silica glass crucible is carried out. In this manner, the silica glass crucible C which has the intermediate layer C5 as shown in FIG. 2 can be produced.

Also, an intermediate layer in which the plurality of bubble-containing layers and transparent glass layers are laminated in the alternate manner can be formed between the outer surface layer and the inner surface layer by intermittently performing evacuation and leakage several times.

Specifically, by the control with the control means 50, when the arc melting which is shown as A in FIG. 6 is initiated at time t0, a suction mode given with the pressure-reducing means 51 which is shown as V in the figure is initiated at the same time of time t0. These are indicated as 'ON' in the figure. In this manner, the quartz-powder laminate 11 starts to melt from the surface at a space side (electrode 13 side) of the mold 10. This melting of the quartz-powder laminate 11 starts from the area corresponding to the outer side surface of the inner surface layer (bubble-free transparent glass layer) C2 and proceeds towards the inner side. The introduction of a leak gas by the pressure-reducing means 51 which is shown as G in the figure is not performed. This is indicated as 'OFF' in the figure.

Next, at time t01 shown in FIG. 6, when a molten state of the quartz-powder laminate 11 reaches a position corresponding to the outer side surface of the inner surface layer (bubble-free transparent glass layer) C2, that is, a thickness position corresponding to the inner side surface of the bubble-containing layer 3, a suction mode given with the pressure-reducing means 51 which is shown as V in the figure is stopped and at the same time, introduction of a leak gas with the pressure-reducing means 51 which is shown as G in the figure is initiated, by the control with the control means 50.

At time t02 shown in FIG. 6, when a molten state of the quartz-powder laminate 11 reaches a position corresponding to the outer side surface of the bubble-containing layer 3, that is, a thickness position corresponding to the inner side surface of the transparent glass layer 4, a suction mode given with the pressure-reducing means 51 which is shown as V in the figure is initiated and at the same time, introduction of a leak gas with the pressure-reducing means 51 which is shown as G in the figure is stopped, by the control with the control means 50.

At time t03 shown in FIG. 6, when a molten state of the quartz-powder laminate 11 reaches a position corresponding to the outer side surface of the transparent glass layer 4, that is, a thickness position corresponding to the inner side surface of the outer surface layer 1, a suction mode given with the pressure-reducing means 51 which is shown as V in the figure is stopped and at the same time, introduction of a leak gas with the pressure-reducing means 51 which is shown as G in the figure is initiated, by the control with the control means 50.

At time t04 shown in FIG. 6, when a molten state of the quartz-powder laminate 11 reaches a position corresponding to the outer side surface of the bubble-containing layer 3, that is, a thickness position corresponding to an inner side surface of the transparent glass layer 4, a suction mode given with the pressure-reducing means 51 which is shown as V in the figure is initiated and at the same time, introduction of a leak gas with the pressure-reducing means 51 which is shown as G in the figure is stopped, by the control with the control means 50.

At time t05 shown in FIG. 6, when a molten state of the quartz-powder laminate 11 reaches a position corresponding to the outer side surface of the transparent glass layer 4, that is, a thickness position corresponding to the inner side surface of the outer surface layer 1, a suction mode given with the pressure-reducing means 51 which is shown as V in the figure is stopped and at the same time, introduction of a leak gas with the pressure-reducing means 51 which is shown as G in the figure is initiated, by the control with the control means 50.

At time t06 shown in FIG. 6, when a molten state of the quartz-powder laminate 11 reaches a thickness position corresponding to the outer side surface of the outer surface layer 1, the arc melting shown as A in the figure is stopped by the control with the control means 50, and a cooling process is initiated.

In the arc melting step, at the time between t0 and t01, removal of bubbles from the corresponding area (inner surface layer C2) of a silica glass crucible is carried out, at the time between t01 and t02, introduction of bubbles to the corresponding area (bubble-containing layer 3) of a silica glass crucible is carried out, at the time between t02 and t03, removal of bubbles from the corresponding area (transparent glass layer 4) of a silica glass crucible is carried out, at the time between t03 and t04, introduction of bubbles to the corresponding area (bubble-containing layer 3) of a silica glass crucible is carried out, at the time between t04 and t05, removal of bubbles from the corresponding area (transparent glass layer 4) of a silica glass crucible is carried out, and at the time between t05 and t06, introduction of bubbles to the corresponding area (outer surface layer 1) of a silica glass crucible is carried out. In this manner, the silica glass crucible C which has the intermediate layer 5 as shown in FIG. 3 can be produced.

When introducing a leak gas while releasing the evacuation upon intermittently performing the evacuation and leakage, it is better to introduce a mixed gas containing 50% or more of helium gas as the leak gas. When helium gas is included as the gas ingredient for gas in bubbles of the bubble-containing layer, the heat conducting effect can be improved further. The concentration of helium gas in a mixed gas to be introduced is preferably 50% or more. At a helium gas concentration of less than 50%, the effect to be achieved by introducing the helium gas will be lowered.

The invention includes a method of manufacturing single-crystal silicon, which includes a step of melting polycrystal silicon in a crucible and a step of pulling a single-crystal silicon ingot by immersing a seed of single-crystal silicon in the molten silicon melt.

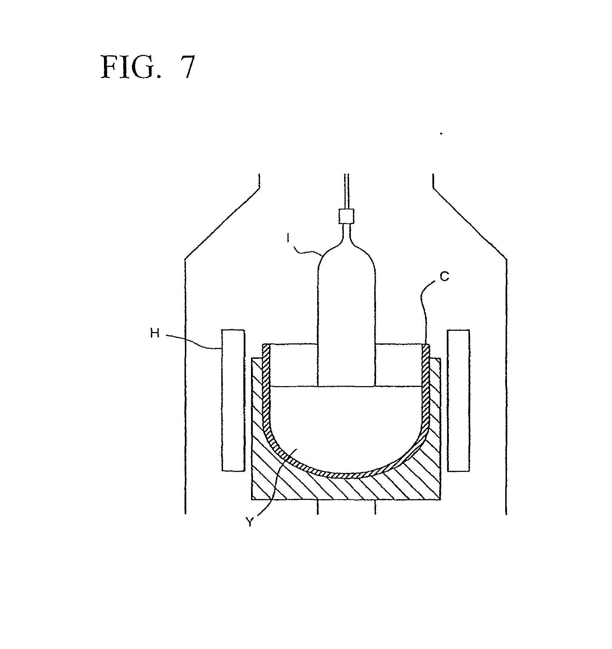

FIG. 7 is a longitudinal cross-sectional view showing a state in which a single-crystal silicon ingot I is pulled out from a silicon melt Y in a silica glass crucible C. When single-crystal silicon is pulled from the silicon melt Y which is melted with a heating means H in a crucible C, according to the Czochralski (CZ) method using the silica glass crucible C of the invention, a locally hot area caused by external radiation is not provided in the silica glass crucible C, and furthermore, the temperature of the silica glass interface becomes more uniform at low temperature than in the known two layer-structured silica glass crucible. Therefore, vibration of the melt surface caused by a SiO gas generation is not generated upon pulling single-crystal silicon.

### Examples

Hereinafter, Examples and Comparative Examples of the invention are shown together.

### Example 1

A silica powder was accumulated to a thickness of 30 mm on the inner side of a rotary mold having an inner diameter of φ630 mm, and the accumulated silica powder was heated from a space side of the mold at 2200°C for arc melting. During this arc melting, evacuation was performed from a rotary mold side to form a transparent inner surface layer. Subsequently, evacuation was released and air leakage was allowed for 60 seconds, and thereafter, evacuation was again performed from the mold side for 60 seconds. These leakage and evacuation were, each at 60-second intervals, sequentially carried out three times to form an intermediate layer. Then, the arc melting was continued for a predetermined period under an air leakage state to form an outer surface layer. After completing the arc melting, cooling was carried out to obtain a silica glass crucible. This crucible was cut and its cross section was observed. On the downside of a 3-mm inner surface layer, an intermediate layer in which a bubble-containing layer having the layer thickness of about 1 mm and a transparent glass layer having the layer thickness of about 1 mm are alternately laminated three times thereby producing three-layered lamination, and the outermost surface layer was a bubble-containing layer having a layer thickness of about 2 mm.

When this crucible was used as a vessel for pulling single-crystal silicon, the time required to give molten silicon by melting polycrystal silicon charged in the vessel was shortened by approximately 20% as compared to the case where the known two-layered silica glass crucible (silica glass crucible including no intermediate layer) was used, and the temperature of the crucible itself was lowered by 4°C. In addition, vibration of the melt surface was not observed upon pulling. When a cross section of the crucible was observed after the pulling, expansion of bubbles was observed, but it was also observed that the state in which transparent glass layers and bubble-containing layers for the intermediate layer form the three-layered lamination is maintained.

### Example 2

In the production of a silica glass crucible by depositing a silica powder on the inner side of a rotary mold according to the same method as in Example 1, after forming a transparent inner surface layer, air was allowed to leak for 120 seconds followed by evacuation for 60 seconds, and this pattern was repeated twice. Thereafter, the arc melting was continued for a predetermined period under an air leakage state to form an outer surface layer. A cross section of this silica glass crucible was observed. On the downside of an inner surface layer, an intermediate layer in which a bubble-containing layer having the thickness of about 2 mm and a transparent glass layer having the thickness of about 1 mm are alternately laminated two times thereby producing two-layered lamination, and the outermost surface layer was a bubble-containing layer having a layer thickness of about 2 mm. When this crucible was used for pulling single-crystal silicon as in Example 1, the time required for increasing the temperature when forming a silicon melt was shortened by approximately 12% as compared to the case where the known two-layered silica glass crucible was used, and the temperature of the crucible was lowered by 3°C. In addition, vibration of the melt surface was not observed upon pulling.

### Example 3

In the production of a silica glass crucible by depositing a silica powder on the inner side of a rotary mold according to the same method as in Example 1, after forming a transparent inner surface layer, evacuation and leakage each for 60 seconds were repeated three times to produce a silica glass crucible. In addition, helium gas was used for a gas to be introduced upon leakage. When this crucible was used as a vessel for pulling single-crystal silicon, the time required for increasing the temperature when forming a silicon melt was shortened by approximately 25% as compared to the case where the known two-layered silica glass crucible was used, and the temperature of the crucible was lowered by 6°C. In addition, vibration of the melt surface was not observed upon pulling. When a cross section of the crucible was observed after the pulling, expansion of bubbles was observed, but it was also observed that the state in which transparent glass layers and bubble-containing layers for the intermediate layer form the three-layered lamination is maintained.

### Comparative Example 1

In the production of a silica glass crucible by depositing a silica powder on the inner side of a rotary mold according to the same method as in Example 1, after forming a transparent inner surface layer, without alternately performing the evacuation and leakage, arc melting was performed for a predetermined period while allowing the air leakage to produce a silica glass crucible. When a cross section of this silica glass crucible was observed, the silica glass crucible had a two-layered structure (including no intermediate layer) in which an outer surface layer (bubble-containing outer side layer) of about 7 mm is formed on the outer side of an inner surface layer (bubble-free transparent glass layer) of about 3 mm. When this crucible was used as a vessel for pulling single-crystal silicon, violent vibration was observed upon pulling.

### Industrial Applicability

Since the intermediate layer in which bubble-containing layers and transparent glass layers are laminated is interposed between an outer surface layer and an inner surface layer, heat from an external radiation is dispersed by the bubble-containing layer to transfer heat over a wide range, and accordingly the temperature distribution of a silica glass interface of the crucible coming in contact with a silicon melt becomes uniform over a wide range thereby uniformly heating the silicon melt. Thus, temperature irregularity in the silicon melt does not occur. In addition, since the transparent glass layers are constituted in addition to the bubble-containing layers, heat dispersed by the bubble-containing layers is efficiently transferred through the transparent glass layer, and thus the property of conducting heat from the high-temperature radiation is significantly improved.

Furthermore, a locally hot area heated by external radiation is not produced, and furthermore, temperature of the silica glass interface becomes uniform at low temperature as compared to the known two-layer-structured silica glass crucible. Therefore, vibration of the melt surface caused by a SiO gas generation is not generated upon pulling single-crystal silicon.

The silica glass crucible can be manufactured by intermittently performing evacuation and leakage in the method of manufacturing a silica glass crucible according to a rotary mold method. Also, an intermediate layer in which the plurality of bubble-containing layers and transparent glass layers are laminated can be formed by intermittently performing evacuation and leakage.

By the use of helium gas which has large heat conductivity as the leak gas upon repeatedly performing intermittent evacuation and leakage, the effect of increasing the temperature by external heating is improved significantly thereby promoting the uniform heating of a silica glass interface.

## Claims

1. A silica glass crucible comprising:
an outer surface layer formed of a bubble-containing silica glass layer;
an inner surface layer formed of a silica glass layer whose bubbles are invisible to the naked eye; and
an intermediate layer interposed between the outer surface layer and the inner surface layer, wherein in the intermediate layer, a bubble-containing silica glass layer (bubble-containing layer) including bubbles with a diameter of 100 µm or smaller by 0.1% or more in the volumetric bubble content and a silica glass layer (transparent glass layer) including the bubbles by 0.05% or less in the volumetric bubble content are laminated.

2. The silica glass crucible according to Claim 1, wherein the layer thickness of both the bubble-containing layer and the transparent glass layer which constitute the intermediate layer is 0.5 mm or more.

3. The silica glass crucible according to Claim 1 or 2, wherein an intermediate layer in which the plurality of bubble-containing layers and transparent glass layers are laminated in the alternate manner is interposed between the outer surface layer and the inner surface layer.

4. A method of manufacturing a silica glass crucible, comprising the steps of:
heating and melting a quartz powder accumulated on the inner surface of a rotary mold from a space side of the mold;
performing evacuation to remove bubbles by sucking air in the quartz powder-deposited layer from the mold side, upon the heating and melting; and
forming a laminated layer of bubble-containing layers and transparent glass layers between the outer surface layer and the inner surface layer by intermittently performing evacuation and leakage.

5. The manufacturing method according to Claim 4, wherein an intermediate layer in which the plurality of bubble-containing layers and transparent glass layers are laminated in the alternate manner is formed between the outer surface layer and the inner surface layer by intermittently performing evacuation and leakage several times.

6. The manufacturing method according to Claim 5 or 6, wherein, upon intermittently performing the evacuation and leakage, a mixed gas containing 50% or more of helium gas is introduced as the leak gas.

7. A method of pulling single-crystal silicon with the use of the silica glass crucible according to any one of claims 1 to 6.
